# EUROPEAN PATENT SPECIFICATION

(11) **EP 0 455 714 B1**
(45) Date of publication and mention of the grant of the patent: **01.09.1993**
(21) Application number: 90902852.4
(22) Date of filing: 30.01.1990
(51) Int. Cl.: H05K 1/05, H05K 3/44

(54) **A METHOD OF MANUFACTURING A SUBSTRATE FOR PLACEMENT OF ELECTRICAL AND/OR ELECTRONIC COMPONENTS**
VERFAHREN ZUR HERSTELLUNG EINES TRÄGERS ZUR BESTÜCKUNG MIT ELEKTRISCHEN UND/ODER ELEKTRONISCHEN BAUELEMENTEN
PROCEDE DE FABRICATION D'UN SUBSTRAT RECEVANT DES COMPOSANTS ELECTRIQUES ET/OU ELECTRONIQUES

(30) Priority: 30.01.1989 NO 890377
(43) Date of publication of application: 13.11.1991
(73) Proprietor: HESTEVIK, Svein, N-1550 Holen (NO); STORFOSSENE, Tore, N-3640 Skollenborg (NO)
(72) Inventor: HESTEVIK, Svein, N-1550 Holen (NO); STORFOSSENE, Tore, N-3640 Skollenborg (NO)
(74) Representative: Davies, Jonathan Mark
(86) International application number: NO9000021
(87) International publication number: WO9009089

(56) References cited:
- EP-A- 0 048 992
- DE-A- 3 527 967
- DE-A- 3 625 087
- DE-A- 3 641 202
- SE-B- 437 207
- US-A- 4 294 009

## Description

The invention relates to a method for manufacturing a substrate for the placement of electrical and/or electronic components thereon in accordance with the preamble of claim 1. Particularly the method according to the present invention concerns the manufacture of substrates with good thermal and mechanical properties and especially suited for use in hybrid modules for power electronics.

In practice, a substrate of the above-mentioned type has the same function as a printed circuit board. Common printed circuit boards for placement of electronic components are usually manufactured of an epoxy material on which is provided a predetermined electrical conducting pattern by means of electroplating. For economical reasons and to reduce the requirement for space, the conducting pattern is usually provided on both sides of the board and the electrical conducting connection between the conducting patterns on each side is provided by through-plated holes in the epoxy substrate. Such circuit boards are however best suited for electronic equipment where low voltages and small currents are used where the equipment is not subjected to mechanical and thermal loads to any degree.

Substrates for use in electrical engineering or electronics where high voltages and large currents are used and where the equipment further may be subjected to large mechanical and thermal loads are often metallic substrates, for instance in form of a sheet of steel and aluminium in order to achieve good thermal conduction and sufficient mechanical strength. Electrical isolation between the conducting pattern and the metal substrate is provided by coating it with an isolation layer, for instance in the form of a enamel coating, alumina coating or a combination of oxides, nitrides of carbonitrides. The isolation layer may also be generated by applying an epoxy resin layer to the metal substrate. The electrical isolation layer may be applied on both sides of the metal substrate or only on one side.

If the substrate for instance will be used in modules of power electronics, the metal substrate in that case usually is provided with or has cooling ribs on the other side in order to transport heat away. The electrical isolation layers are provided with an electrical conduction pattern or current leads by means of different processes, for instance by chemical methods or by vapour deposition. Examples of circuit boards of this type are for instance disclosed in DE-PS 3447520 and DE-OS 2556826.

From GB-PS 2110475A there is further known the use of a substrate in the form of an alloy of Fe, Cr, Al, and Yt where a ceramic surface layer is formed by the substrate being heated in an oxidizing atmosphere.

The known circuit boards or substrates as well as the methods used in their manufacture are, however, burdened with a number of disadvantages. Different processes are used in application of the isolation and the conducting layer and those processes are often of such a nature that they in a negative way influence the properties of already applied coatings. It has proved to be difficult to achieve dielectric layers with satisfactory dielectric, thermal and mechanical properties and when these properties then are influenced in a negative way by providing a conducting pattern or by soldering of components thereto, the finished product hardly meets the requirements that are demanded of it, e.g. hybrid modules in power electronics. It is for instance difficult to achieve a satisfactory bond between the different layers or the isolation layer and the metal substrate which forms the core or base and the dielectric strength of the electrical isolation layer is not as good as desired. One solution might be to increase the thickness of the electrical isolation layer, but this is an expensive solution and in the case of ceramic coatings it does in any case not lead to any improvement, as the coatings usually are brittle and have a relatively low tensile and shear strength, although they are hard materials and in theory have a high dielectric strength. The last property, however, is reduced due to the formation of pores and impurities caused by migration. It has also turned out that ceramic layers applied by means of, for instance, plasma spraying do not attain better dielectrical properties if the thickness is increased beyond 0,3 mm. In addition the use of different processes for applying the separate layers to the metal substrate impairs manufacturing economy.

From the document EP-A-0 048 992 there is known a method whereby the pores in the ceramic layer are filled with a resin with a network, strongly bonded to the ceramic.

The object of the present invention therefore is to avoid above-mentioned and other disadvantages, as the present invention provides a method for the manufacture of substrates having high mechanical and dielectrical strength that are able to sustain great thermal loads and in which the same process may be used for coating a base, preferably of a metallic material, with both the electrical isolation and conducting layers.

The method according to the invention is distinguished by the features disclosed in the characterizing part of claim 1, whereas further features and advantages of the method are disclosed by the attached dependent claims.

The method will be explained by a typical process example and in connection with the attached drawings.

Fig. 1 shows a section of a substrate according to prior art.

Fig. 2 shows schematically a plasma spray gun used with the method according to the present invention.

Fig. 3 shows a section of a substrate manufactured according to the method of the present invention.

Fig. 4 shows the application of an electrical conducting layer in the form of a conducting pattern.

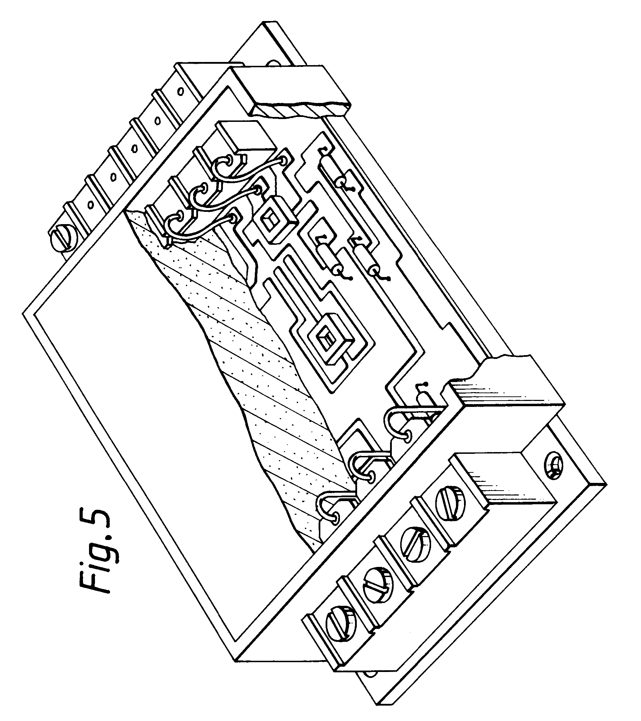

Fig. 5 shows in perspective and with a partly exposed substrate, a completed, mounted hybride module for power electronics.

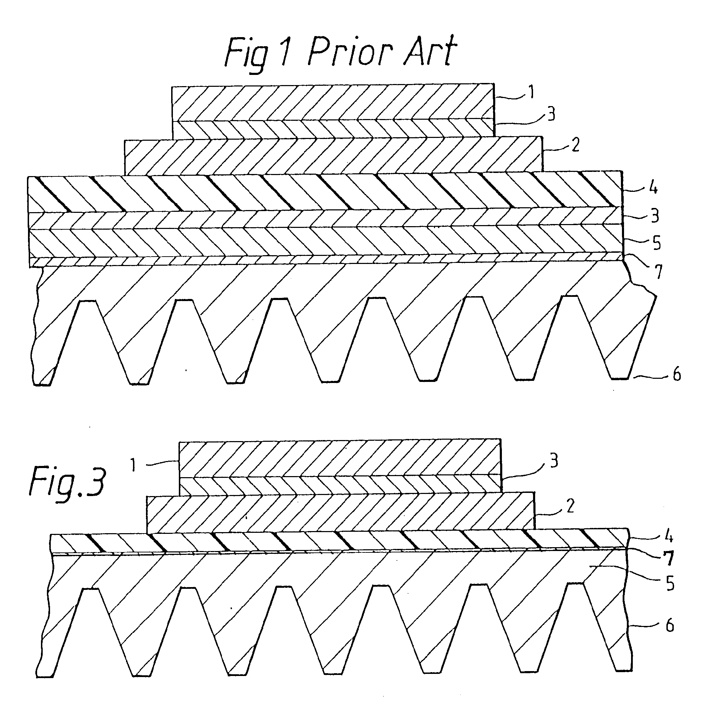

In Fig. 1 there is shown a substrate according to prior art with a transistor matrix 1 mounted on a conducting layer 2 by means of a conducting adhesive 3 or by soldering. Many different layers which make up the substrate are applied by means of different processes and the insulation layer 4 is for instance glued to the base 5, while the heat sink or the cooling body 6 is a separate component. The method according to the present invention is described, by way of example, in connection with the manufacture of a substrate for one-sided placement of components as shown in section in Fig. 3. The thermal coating process used in the following example is plasma spraying. The base 5, which may be a metal sheet, preferably of steel, aluminium or copper, is cleaned or degreased on that side of the surface which is to be coated with the isolation layer 4 by being sprayed with trichlorethene, acetone, or the like. Then the surface is sandblasted in a first process step with alumina (Al₂O₃), for instance "Metcolite" with a grain size of 0,2-0,8µm. The process parameters used in this step may for instance be:
- Blasting pressure: 3-6 bar
- Nozzle diameter: 4-8 mm
- Distance: 100-200 mm
- Blasting angle: 60-90°
- Surface roughness: 20µm (mean)

The sandblasted surface must immediately thereafter be cleaned of dust by blasting with completely dry and greasefree compressed air or nitrogen gas.

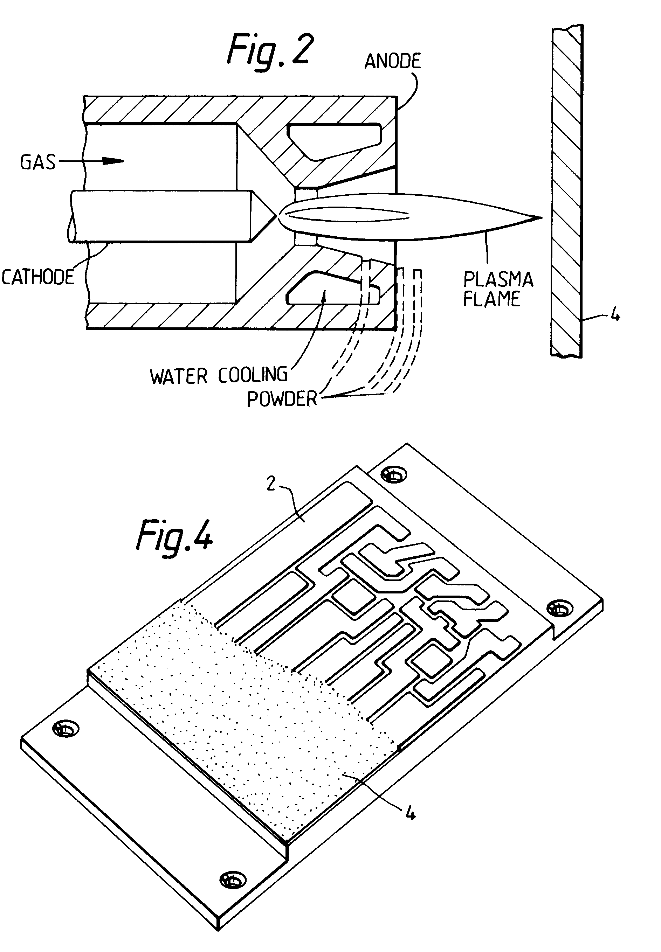

In the next process step which takes place at the most 1 to 2 hours after the sandblasting, the surface is coated with a bonding layer 7 by means of plasma spraying. The objective of the bonding layer 7 is to function as a carrier for the ceramic layer 4 which constitutes the dielectric coating. The bonding layer 7 is preferably made of copper powder of the type PT2901, Metco 56 or the like. The copper powder is sprayed in a plasma process with the use of a plasma gun of a type shown schematically in Fig. 2. In this process step the substrate, i.e. the work piece, or the pistol is moved with a velocity of 1 m/s. At the same time the plasma spray gun is continuously moved in a direction at right angles to the substrate with a speed of 5 mm per pass. The bonding layer 7 is applied to a thickness of 0,05-0,15 mm, the applied thickness in each pass being 15 µ. The parameters used in this process step are:
- Current strength: 300-500 A
- Voltage: 50-65 V
- Distance (approximate): 150 mm
- Argon gas feed: 50-70 l/min
- Hydrogen gas feed: 6 l/min
- Powder feed: 50 g/min

A dielectric layer 4 of ceramic material is now applied in a consecutive process step immediately after application of the bonding layer 7. The ceramic layer 4 consists of alumina alternatively mixed with 25% zirconia. The grain size is typically 10-110 µm, for instance by use of Metco 105 SFP. If the ceramic layer 4 is spray coated with a metal layer, a composition of 25% by weight zirconia (ZrO₂) is used. The parameters used in this process step are:
- Current strength: 550-1000 A
- Voltage: 50-75 V
- Distance: 90-110 mm
- Argon gas feed: 30-40 l/min
- Hydrogen gas feed: 50-20 l/min
- Powder feed: 20-1100 g/min
- Passage thickness: 2-15 µm
- Layer thickness: 0,3 mm

During application of the ceramic layer 4 the temperature of the substrate must be between 50-150°C. This is easily achieved by the substrate being force-cooled with air.

In the following process step the ceramic layer 4 is impregnated in order to achieve the desired dielectrical properties. As the substrate temperature is below 50°C, but above the room temperature silicone oil, preferably of the type Baysilone 100 is applied with a suitable tool as a brush, spray gun etc., to form a visible, shiny film which can be seen all over the surface. On application, the silicone oil is absorbed into the ceramic layer 4 while excess silicone oil is removed from the surface for instance by use of a moisture absorbent, porous paper This paper is pressed two to five times against the surface, so that in the end there is no visible silicone oil.

In a subsequent process step the dielectric layer now is coated with a conducting pattern or a current lead pattern of copper. This must take place within one hour after the plasma spraying of the ceramic material. A desired conducting pattern is achieved by plasma spraying a copper powder through a template of stainless steel in the form of a sheet of 2 to 3 mm thickness, in which the desired conducting pattern has been cut beforehand by means of a laser. It is to be understood that the conducting pattern is determined by the electrical function to be realized by the substrate. The distance between the template and the ceramic layer 4 must be between 0,5 and 1 mm. The substrate with the ceramic coating is preheated by means of plasma to about 50°C by using the same plasma gun which was used for spraying. The same copper powder is used for the conducting pattern, i.e. the electrical conducting layer 2, as for the bonding layer, i.e. PT 2901, Metco 56 or the like. The parameters for the spraying velocity and the vertical feed are also the same as for the bonding layer. The parameters used in this process step are:
- Current strength: 300-500 A
- Voltage: 50-65 V
- Distance: 150 mm
- Argon gas feed: 50-70 l/min
- Hydrogen gas feed: 5 l/min
- Powder feed: 50 g/min
- Passage thickness: 0,05-0,15 mm
- Layer thickness: 0,1-1 mm

The copper layer may be sprayed to the desired dimension or with an 0,1 mm excess. In the last case the layer is smoothed or made plane by grinding, milling or comparable processes.

In the final process step the substrate is cleaned to remove possible copper dust. This is done by blasting it with small glass spheres in a separate chamber in order to avoid silicone pollution of the conducting pattern. Care must be taken in this process, where the parameters used are:
- Pressure: 2-5 bar
- Nozzle diameter: 1-6 mm
- Distance: abt. 150 mm
- Sphere diameter: 50-100 µm

By the method disclosed in the above example a substrate is provided that is very well suited for use in the production of, for instance, hybride modules for power electronics, but which also may be employed generally in electronics where substrates of high mechanical strength and excellent thermal and dielectric properties are desired. Further such substrates may be used in non-traditional applications in electrical engineering and in that connection possibly included as an integrated part of a more comprehensive electronic and mechanical equipment. The metallic base 5 may then for instance be a part of the construction itself and coated with the dielectric layer 4 by means of plasma spraying in situ for later placement of electrical or electronic components.

A substrate manufactured as specified above is very well suited for use in an automatic production process for the manufacture of miniaturized hybrid circuit modules in the form of ready-made packages. The achieved reduction of costs in this connection amounts to about 20% relative to traditional methods and results from the manufacture of a circuit package in a volume reduction of up to 70%. The manufacturing method is also well suited for the production of custom specified circuits and offers good possibilities for a possible optimization of the circuit module, while the specific demands for mechanical and thermal properties may be achieved. It has thus been shown that the method is well suited to small production volumes with a frequent change of the circuit pattern, as the initial costs are low.

The economical and process engineering advantages are first and foremost achieved by the coating being based on the use of a thermal coating process, e.g. plasma spraying or jet coating. Besides it is well known to use thermal coating processes in the mechanical industry for instance for coating metals with wear resistant coatings of ceramic materials. By integrating the ceramic coating 4 with a base 5 of metallic material, good heat conducting properties are achieved and when the thermal coating process also is used for applying the electrical conducting coating 2 in the form of predetermined conducting patterns, a substrate with excellent thermal conducting properties results.

For the coating there may be used different thermal processes. It has shown to be particularly advantageous to use plasma spraying for applying the ceramic coating 4 forming a ceramic coating with 5% pore volume and 5% oxide (volume). It is, however, desired that the conducting coating 2 which cannot be impregnated, has greater density and lower oxide content. This is advantageously achieved by the conducting layer being applied by means of jet coating, for instance with Metco "Diamondjet" which produces a conducting layer with only 2% pore volume and 2% oxide volume.

Moreover, by jet coating, where high speed jet combustion gases from the combustion of for instance propane are used, the parameters of current strength, voltage and gas feed given in the relevant process example do not apply.

Although a substrate made according to the above-mentioned example only can be used for one sided mounting of components, it has been shown that it has a lower cost per area unit than conventional double-sided circuit boards of epoxy resin, when the price of the metal base used is ignored as the metal base possibly could be part of a more comprehensive structure where the electrical or the electronic components are used.

By means of the method according to the invention there are thus provided a substrate with a thermal resistance of 0,6°C/W (computed), when a 10 mm base of aluminium sheet is used, a volume resistivity of 25.10¹² ohm/m² with a thickness of the ceramic layer of 0,3 mm, a dielectric strength of 3000 V for the same thickness of the ceramic layer and an electrical conductivity of the plasma sprayed copper layer of 40 to 50% to that of pure copper, but which is 1000 times greater than the conductivity of a thickfilm paste.

The use of a thermal process in the application of the ceramic coating has shown to be very well compatible with different base materials and when a thermal coating process also is used for applying conducting patterns, it may easily be integrated with various technologies and methods for the mounting of components.

## Claims

1. A method for manufacturing of a substrate for placement of electrical and/or electronical components, the substrate at least comprising a base preferably formed of a metalic material which possible may constitute a part of or being integrated in a more comprehensive structure, a dielectric layer and an electrical conducting layer which forms a predetermined pattern, characterized in that the method comprises the following successive steps:
a) sandblasting the surface of the base with grains of Al₂O₃ (alumina),
b) coating the sandblasted surface of the base with a bonding layer by means of thermal coating process,
c) coating the bonding layer with a dielectric layer by means of a thermal coating process, the dielectric layer being formed of a ceramic material,
d) impregnating the dielectric layer formed of ceramic material with silicone oil,
e) coating the dielectric layer with the electrical conducting layer by means of a thermal coating process, a template being used to form the predetermined pattern, and
f) cleaning the surface of the dielectrical layer and the electrical conducting layer by blasting with spheres of glass.

2. A method according to claim 1,
characterized in that the thermal coating process is plasma spraying.

3. A method according to claim 1,
characterized in that the thermal coating process is jet coating.

4. A method according to one of the preceeding claims, characterized in that plasma spraying are used in step c) and jet coating in step d).

5. A method according to claim 1,
characterized in that the impregnation in step d) takes place by applying silicone oil on the surface of the dielectric layer, so that there on the surface a visible film of silicone oil is formed, whereafter the excess silicone oil immediately after the application is removed from the surface such that the film of silicone oil no longer is visible.

6. A method according to claim 1, characterized in that the coating of the bonding layer in step b) takes place at most one to two hours after step a).

7. A method according to claim 1-4 or 6,
characterized in that the bonding layer are formed of a copper powder.

8. A method according to claim 1-4,
characterized in that the dielectric layer are formed of alumina powder (Al₂O₃ powder).

9. A method according to claim 1-4,
characterized in that the dielectric layer is formed of a composition of powder of alumina (Al₂O₃) and zirconia (ZrO₂), preferably with 25%-by-weight zirconia.

10. A method according to any of the claims 1, 8 or 9,
characterized in that the dielectric layer preceding step e) is preheated to about 50°C, preferably by means of plasma.

## Patentansprüche

1. Verfahren zur Herstellung eines Trägers zur Bestükkung mit elektrischen und/oder elektronischen Bauteilen, wobei der Träger wenigstens einen Grundkörper aus einem vorzugsweise metallischen Werkstoff aufweist, der Teil einer umfangreicheren Anordnung sein kann oder in eine solche integriert sein kann und der eine nichtleitende Schicht und eine elektrisch leitende Schicht aufweist, die ein vorher festgelegtes Muster bildet, **gekennzeichnet durch** folgende aufeinanderfolgende Verfahrensschritte:
a) Sandstrahlen der Oberfläche des Grundkörpers mit Al₂O₃-Körnern (Aluminiumoxid);
b) Beschichten der sandgestrahlten Oberfläche des Grundkörpers mit einer Bindeschicht in einem thermischen Beschichtungsverfahren;
c) Beschichten der Bindeschicht mit einer nichtleitenden Schicht in einem thermischen Beschichtungsverfahren, wobei die nichtleitende Schicht von einem keramischen Werkstoff gebildet wird;
d) Imprägnieren der nichtleitenden Schicht aus Keramikwerkstoff mit Silikonöl;
e) Beschichten der nichtleitenden Schicht mit der elektrisch leitenden Schicht in einem thermischen Beschichtungsverfahren, wobei eine Schablone verwendet wird, um das vorherbestimmte Muster zu erzeugen; und
f) Reinigen der Oberfläche der elektrisch nichtleitenden Schicht und der elektrisch leitenden Schicht durch Kugelstrahlen mit Glaskugeln.

2. Verfahren nach Anspruch 1, **dadurch gekennzeichnet, daß** das thermische Beschichtungsverfahren ein Plasma-Spritzverfahren ist.

3. Verfahren nach Anspruch 1, **dadurch gekennzeichnet, daß** das thermische Beschichtungsverfahren ein Strahl-Beschichtungsverfahren ist.

4. Verfahren nach einem der vorstehenden Ansprüche, **dadurch gekennzeichnet, daß** das Plasma-Spritzverfahren im Verfahrensschritt c) und das Strahl-Beschichtungsverfahren im Verfahrensschritt d) verwendet wird.

5. Verfahren nach Anspruch 1, **dadurch gekennzeichnet, daß** das Imprägnieren im Verfahrensschritt d) dadurch erzielt wird, daß Silikonöl auf die Oberfläche der nichtleitenden Schicht aufgebracht wird, so daß sich auf der Oberfläche ein sichtbarer Silikonölfilm ausbildet, wonach das überschüssige Silikonöl unmittelbar nach seinem Aufbringen wieder von der Oberfläche entfernt wird, so daß der Silikonölfilm nicht länger sichtbar ist.

6. Verfahren nach Anspruch 1, **dadurch gekennzeichnet, daß** das Beschichten mit der Bindeschicht im Verfahrensschritt b) spätestens 1 bis 2 Stunden nach dem Verfahrensschritt a) durchgeführt wird.

7. Verfahren nach einem der Ansprüche 1 bis 4 oder 6, **dadurch gekennzeichnet, daß** die Bindeschicht aus Kupferpulver besteht.

8. Verfahren nach einem der Ansprüche 1 bis 4, **dadurch gekennzeichnet, daß** die nichtleitende Schicht von Aluminiumoxid-Pulver (Al₂O₃- Pulver) gebildet wird.

9. Verfahren nach einem der Ansprüche 1 bis 4, **dadurch gekennzeichnet, daß** die nichtleitende Schicht aus einer Mischung aus Aluminiumoxid-Pulver (Al₂O₃) und Zirkonerde (ZrO₂) besteht, wobei der Anteil der Zirkonerde vorzugsweise etwa 25 Gew. % beträgt.

10. Verfahren nach einem der Ansprüche 1, 8 oder 9, **dadurch gekennzeichnet, daß** die nichtleitende Schicht vor dem Verfahrensschritt e) vorzugsweise durch eine Plasmaeinrichtung auf etwa 50°C vorgewärmt wird.

## Revendications

1. Procédé de fabrication d'un substrat recevant des composants électriques et/ou électroniques, le substrat comprenant au moins une couche de base formée de préférence d'un matériau métallique qui peut constituer une partie d'une structure plus globale ou être intégré dans cette structure plus globale, une couche diélectrique et une couche électro-conductrice qui forme une configuration prédéterminée, caractérisé en ce qu'il comprend les étapes successives suivantes :
a) le décapage de la surface de la couche de base par projection de particules d'Al₂O₃ (alumine),
b) le revêtement de la surface décapée de la couche de base par une couche de liaison, par des moyens de procédé thermique de revêtement,
c) le revêtement de la couche de liaison par une couche diélectrique, par des moyens de procédé thermique de revêtement, la couche diélectrique étant formée d'un matériau céramique,
d) l'imprégnation de la couche diélectrique formée d'un matériau céramique avec une huile de silicone,
e) le revêtement de la couche diélectrique par la couche électro-conductrice, par des moyens de procédé thermique de revêtement, un gabarit étant utilisé pour former la configuration prédéterminée, et
f) le nettoyage de la surface de la couche diélectrique et de la couche électro-conductrice par projection de billes de verre.

2. Procédé selon la revendication 1, caractérisé en ce que le procédé thermique de revêtement est une pulvérisation de plasma.

3. Procédé selon la revendication 1, caractérisé en ce que le procédé thermique de revêtement est un procédé de revêtement au jet.

4. Procédé selon l'une quelconque des revendications précédentes, caractérisé en ce que la pulvérisation de plasma est utilisée dans l'étape c) et le revêtement au jet est utilisé dans l'étape d).

5. Procédé selon la revendication 1, caractérisé en ce que l'imprégnation dans l'étape d) est réalisée par application d'huile de silicone sur la surface de la couche diélectrique, de telle sorte qu'il y a formation, à la surface, d'un film visible d'huile de silicone, après quoi l'excès d'huile de silicone est éliminé immédiatement après l'application à partir de la surface, de telle sorte que le film d'huile de silicone ne soit plus visible.

6. Procédé selon la revendication 1, caractérisé en ce que le revêtement de la couche de liaison dans l'étape b) est réalisé au plus une ou deux heures après l'étape a).

7. Procédé selon la revendication 1 à 4 ou 6, caractérisé en ce que la couche de liaison est formée d'une poudre de cuivre.

8. Procédé selon la revendication 1 à 4, caractérisé en ce que la couche diélectrique est formée d'une poudre d'alumine (poudre d'Al₂O₃).

9. Procédé selon la revendication 1 à 4, caractérisé en ce que la couche diélectrique est formée d'une composition d'une poudre d'alumine (poudre d'Al₂O₃) et de zircone (ZrO₂), de préférence avec 25% en poids de zircone.

10. Procédé selon l'une des revendications 1, 8 ou 9, caractérisé en ce que la couche diélectrique précédant l'étape e) est préchauffée à environ 50°C, de préférence par des moyens à plasma.
